# EUROPEAN PATENT SPECIFICATION

(11) **EP 2 617 862 B1**
(45) Date of publication and mention of the grant of the patent: **06.08.2014**
(21) Application number: 12199131.9
(22) Date of filing: 21.12.2012
(51) Int. Cl.: C23C 14/16

(54) **Oxidation resistant coating with substrate compatibility**
Oxidationsbeständige Beschichtung mit Substratkompatibilität
Revêtement résistant à l'oxydation avec compatibilité à un substrat

(30) Priority: 27.12.2011 US 201113337542
(43) Date of publication of application: 24.07.2013
(73) Proprietor: United Technologies Corporation, Hartford, CT 06101 (US)
(72) Inventor: ZIMMERMAN, Benjamin Joseph, Enfield, CT Connecticut 06082 (US); MALONEY, Michael J., Marlborough, CT Connecticut 06447 (US)
(74) Representative: Leckey, David Herbert

(56) References cited:
- EP-A1- 2 145 969
- US-A1- 2006 141 283
- US-A1- 2007 264 523
- US-A1- 2009 035 601

## Description

This disclosure relates to the field of protective coatings for use on metallic parts which are used at elevated temperatures and have particular utility in the field of gas turbine engines.

Current metallic coatings on hot section turbine engine components provide oxidation and corrosion protection and act as bond coats for ceramic thermal barrier coatings on parts or components used in gas turbine engines. Both MCrAlY and aluminide coatings were developed to ensure acceptable performance on then-current base alloys used for part or component substrates. More recent single crystal substrate alloys, while providing improved mechanical properties, exhibit oxidation debits and detrimental reaction zones with current bond coats.

EP 2 145 965 discloses a TBC comprising 1.0-15 Co, 5.0-18 Cr, 5.0-12 Al, 0.01-1.0 Y, 0.01-0.6 HF, 0.0-0.3 Si, 0.0-0.1 Zr and a balance of Ni.

It is important for the turbine engine components to have a coating which is compatible with the substrate material.

### SUMMARY

In accordance with the present disclosure, there is provided a coating which is compatible with nickel- and cobalt-based superalloys.

In accordance with the present disclosure, there is provided a coating which comprises from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel.

In particular there is provided an oxidation resistant coating for use on a turbine engine component comprising from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel.

Further, in accordance with the present disclosure, there is provided a part, such as a turbine engine component, having a substrate and a coating applied to the substrate, which coating comprises from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel.

Other details of the oxidation resistant coating having substrate compatibility are set forth in the following drawings and detailed description in which like reference numerals depict like elements.

### BRIEF DESCRIPTION OF THE DRAWING(S)

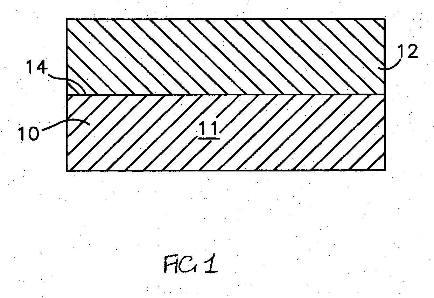

Figure 1 illustrates a part having a coating applied thereto.

### DETAILED DESCRIPTION OF THE PREFERRED EMBODIMENT(S)

Referring now to the drawings, a part 10, such as a turbine engine component, having a substrate 11 to which is applied a coating 12 which imparts oxidation resistance to the part and which is compatible with the material forming the part. If desired, the coating 12 may be applied directly to a surface 14 of the substrate.

The substrate 11 may be formed from a wide range of metallic materials including, but not limited to, nickel-based and cobalt-based superalloys. For example, the substrate 11 may be a single crystal nickel-based superalloy.

The coating 12 comprises from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel. As can be seen from the above composition, there is a reduced aluminum content which provides a reduction in the formation of SRZ in alloys that are prone to it. More aluminum in the coating 12 may create reaction zone problems, while less aluminum does not provide enough aluminum to maintain a good protective scale. Less reactive elements (Y, Hf, Si, and Zr) may increase oxidation kinetics, while more reactive elements may lead to short-circuit oxidation. More chromium may reduce the dominant phase, gamma prime and less chromium may hurt hot corrosion resistance. A highly desirable composition for the coating 12 lies right in the middle of the above ranges.

The coating 12 may be applied using either plasma spray or physical vapor deposition techniques to the substrate 11 from which the part 10 is formed. For example, the coating may be applied using cathodic arc deposition.

The coating 12 has particular utility as a bond coat. In such a situation, the coating 12 would be applied directly onto at least one surface 14 of the substrate 11. A thermal barrier coating (not shown) may be applied over the coating 12.

The coating described herein shows much less formation of a secondary reaction zone than with traditional MCrAlYs or with aluminide or platinum-aluminide coatings, particularly when used on higher generation single crystal alloys which may suffer from microstructural instability. The elements which make these superalloys strong and creep resistant can make them prone to instability, especially in the vicinity of a coating. Aluminum diffusion from the coating is known to exacerbate this problem. This is because aluminum from the coating may combine with the alloy and form a layer known as the secondary reaction zone. This layer has poor mechanical properties and is associated with topologically close-packed (TCP) features which can encourage cracking and transition to a gamma prime matrix (rather than a gamma matrix in the rest of the alloy). As noted above, there is less formation of SRZ with the coatings described herein.

A coating having the composition described herein exhibits corrosion resistance, high temperature oxidation resistance, and mechanical properties similar to MCrAlY coatings. The EB-PVD thermal barrier coating spallation resistance for this coating is 8X that of the baseline coating. A part having an oxidation resistant coating having a composition in accordance with the present disclosure and a thermal barrier coating was subjected to burner rig testing and 2050°F (1121°C). It was found that the coating had an average thermal barrier coating spallation which was 864% of a composition coating formed from a traditional NiCoCrAlY material with higher cobalt and chromium levels. Burner rig testing showed the coating described herein had an oxidation resistance which was 92% of the comparison coating (burner rig @ 2150°F (1177°C)), a hot corrosion resistance which was 130% of the comparison coating (burner rig @ 1600°F (871°C)) and high cycle fatigue and thermo-mechanical fatigue equivalent to the comparison coating.

There has been provided herein an oxidation resistant coating with substrate compatibility. While the coating has been described in the context of particular embodiments thereof, other unforeseen alternatives, modifications, and variations may become apparent to those skilled in the art having read the foregoing description. Accordingly, it is intended to embrace those alternatives, modifications, and variations as fall within the scope of the appended claims.

## Claims

1. A coating comprising from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel.

2. A part (10) comprising a substrate (11) and a coating (12) according to claim 1 deposited on a surface (14) of said substrate (11).

3. The part according to claim 2, wherein said substrate (11) comprises a nickel-based superalloy.

4. The part according to claim 2, wherein said substrate (11) comprise a cobalt-based superalloy.

5. The part according to any of claims 2 to 4, wherein said coating (12) is applied directly to a surface (14) of said substrate (11).

6. The part according to any of claims 2 to 5, wherein said part (10) is a turbine engine component.

7. The coating of claim 1 being an oxidation resistant coating for use on a turbine engine component.

8. A process for forming an oxidation resistant coating (12) on a part (10), said process comprising the steps of:
providing a part (10) having a substrate (11);
forming a coating (12) on a surface (14) of said substrate (11); and
said coating forming step comprising forming a coating (12) comprising from 11 to 14 wt% chromium, from 11 to 14 wt% cobalt, from 7.5 to 9.5 wt% aluminum, from 0.20 to 0.60 wt% yttrium, from 0.10 to 0.50 wt% hafnium, from 0.10 to 0.30 wt% silicon, from 0.10 to 0.20 wt% zirconium, and the balance nickel.

9. The process according to claim 8, wherein said part providing step comprises providing a part (10) having a substrate (11) formed from one of a nickel-based superalloy and a cobalt-based superalloy.

## Patentansprüche

1. Beschichtung aufweisend von 11 bis 14 Gew.% Chrom, von 11 bis 14 Gew.% Kobalt, von 7,5 bis 9,5 Gew. % Aluminium, von 0,20 bis 0,60 Gew. % Yttrium, von 0,10 bis 0,50 Gew. % Hafnium, von 0,10 bis 0,30 Gew. % Silizium, von 0,10 bis 0,20 Gew. % Zirconium, und Rest Nickel.

2. Teil (10) aufweisend ein Substrat (11) und eine Beschichtung (12) nach Anspruch 1, die auf einer Oberfläche (14) des Substrats (11) abgeschieden ist.

3. Teil nach Anspruch 2, wobei das Substrat (11) eine Superlegierung auf Nickelbasis aufweist.

4. Teil nach Anspruch 2, wobei das Substrat (11) eine Superlegierung auf Kobaltbasis aufweist.

5. Teil nach einem der Ansprüche 2 bis 4, wobei die Beschichtung (12) direkt auf eine Oberfläche (14) des Substrats (11) aufgebracht ist.

6. Teil nach einem der Ansprüche 2 bis 5, wobei das Teil (10) eine Turbinenmaschinenkomponente ist.

7. Beschichtung nach Anspruch 1, die eine oxidationsbeständige Beschichtung zur Verwendung auf einer Turbinenmaschinenkomponente ist.

8. Verfahren zur Ausbildung einer oxidationsbeständigen Beschichtung (12) auf einem Teil (10), wobei das Verfahren folgende Schritte aufweist:
Bereitstellen eines Teils (10) mit einem Substrat (11);
Ausbilden einer Beschichtuung (12) auf einer Oberfläche (14) des Substrats (11) ; und wobei
der Schritt des Ausbildens der Beschichtung ein Ausbilden einer Beschichtung (12) aufweist, die von 11 bis 14 Gew.% Chrom, von 11 bis 14 Gew. % Kobalt, von 7, bis 9,5 Gew. % Aluminium, von 0,20 bis 0,60 Gew. % Yttrium, von 0,10 bis 0,50 Gew. % Hafnium, von 0,10 bis 0,30 Gew. % Silizium, von 0,10 bis 0,20 Gew.% Zirconium, und Rest Nickel aufweist.

9. Verfahren nach Anspruch 8, bei dem der Schritt des Bereitstellens des Teils ein Bereitstellen eines Teils (10) aufweist, das ein Substrat (11), das aus einer Superlegierung auf Nickelbasis oder aus einer Superlegierung auf Kobaltbasis ausgebildet ist, besitzt.

## Revendications

1. Revêtement comprenant 11 à 14 % en poids de chrome, 11 à 14 % en poids de cobalt, 7,5 à 9,5 % en poids d'aluminium, 0,20 à 0,60 % en poids d'yttrium, 0,10 à 0,50 % en poids d'hafnium, 0,10 à 0,30 % en poids de silicium et 0,10 à 0,20 % en poids de zirconium, le restant étant formé de nickel.

2. Pièce (10) comprenant un substrat (11) et un revêtement (12) selon la revendication 1 déposé sur une surface (14) dudit substrat (11).

3. Pièce selon la revendication 2, dans laquelle ledit substrat (11) comprend un superalliage à base de nickel.

4. Pièce selon la revendication 2, dans laquelle ledit substrat (11) comprend un superalliage à base de cobalt.

5. Pièce selon l'une quelconque des revendications 2 à 4, dans laquelle ledit revêtement (12) est appliqué directement à une surface (14) dudit substrat (11).

6. Pièce selon l'une quelconque des revendications 2 à 5, dans laquelle ladite pièce (10) est un composant de moteur à turbine.

7. Revêtement selon la revendication 1, qui est un revêtement résistant à l'oxydation pour usage sur un composant de moteur à turbine.

8. Procédé de formation d'un revêtement résistant à l'oxydation (12) sur une pièce (10), ledit procédé comprenant les étapes consistant à :
fournir une pièce (10) ayant un substrat (11) ;
former un revêtement (12) sur une surface (14) dudit substrat (11) ; et
ladite étape de formation du revêtement comprend la formation d'un revêtement (12) comprenant 11 à 14 % en poids de chrome, 11 à 14 % en poids de cobalt, 7,5 à 9,5 % en poids d'aluminium, 0,20 à 0,60 % en poids d'yttrium, 0,10 à 0,50 % en poids d'hafnium, 0,10 à 0,30 % en poids de silicium et 0,10 à 0,20 % en poids de zirconium, le restant étant formé de nickel.

9. Procédé selon la revendication 8, dans lequel ladite étape de fourniture de pièce comprend la fourniture d'une pièce (10) ayant un substrat (11) formé à partir de l'un ou l'autre d'un superalliage à base de nickel et d'un superalliage à base de cobalt.
